# EUROPEAN PATENT APPLICATION

(11) **EP 4 400 636 A1**
(43) Date of publication of application: **17.07.2024**
(21) Application number: 22867160.8
(22) Date of filing: 18.08.2022
(51) Int. Cl.: C30B 29/38, C23C 16/02, C23C 16/34, C30B 25/10, C30B 25/18, H01L 21/20, H01L 21/205

(54) **METHOD FOR MANUFACTURING NITRIDE SEMICONDUCTOR SUBSTRATE**

(30) Priority: 09.09.2021 JP 2021147011
(71) Applicant: Shin-Etsu Handotai Co., Ltd., Tokyo 100-0004 (JP)
(72) Inventor: HAGIMOTO Kazunori, Annaka-shi, Gunma 379-0196 (JP); KUBONO Ippei, Annaka-shi, Gunma 379-0196 (JP)
(74) Representative: Mooser, Sebastian Thomas
(86) International application number: PCT/JP2022/031163
(87) International publication number: WO 2023/037838

(57) **Abstract**

The present invention provides a method for manufacturing a nitride semiconductor substrate in which a nitride semiconductor is formed on a substrate for film formation; the method includes (1) subjecting a substrate for film formation made of single-crystal silicon to heat treatment under a nitrogen atmosphere to form a silicon nitride film on the substrate for film formation, (2) growing an AlN film on the silicon nitride film, and (3) growing a GaN film, an AlGaN film, or both on the AlN film. This provides a method for manufacturing a nitride semiconductor substrate that can prevent diffusion of Al to the high-resistance single-crystal silicon substrate when the AlN layer is epitaxially grown on the high-resistance single-crystal silicon substrate, and the GaN or the AlGaN layer is epitaxially grown on top of that.

## Description

### TECHNICAL FIELD

The present invention relates to a method for manufacturing a nitride semiconductor substrate, in particular, a method for manufacturing a nitride semiconductor substrate for a high-frequency device.

### BACKGROUND ART

Nitride semiconductors, including GaN and AlN, can be used to produce high-electron mobility transistors (HEMT: High Electron Mobility Transistor) and electronic devices with a high breakdown voltage using two-dimensional electron gas.

It is difficult to produce a nitride wafer with these nitride semiconductors grown on a substrate. Thus, a sapphire substrate or a SiC substrate is used as the substrate. However, in order to achieve larger diameter and cost reduction of the substrate, epitaxial growth by vapor phase growth on a silicon substrate is employed. In producing an epitaxially grown film by vapor phase growth on a silicon substrate, a substrate with a larger diameter compared to the use of the sapphire substrate or the SiC substrate can be used. Therefore, the productivity of devices is high, and there is an advantage in heat dissipation properties.

An AlN buffer layer, a buffer layer, and a GaN-HEMT structure epitaxial layer are laminated sequentially on a single-crystal silicon substrate to make an epitaxial wafer for a power device and an RF device. In particular, a high-resistance substrate is used for the single-crystal silicon substrate of the epitaxial wafer for an RF device. The AlN buffer layer is laminated on a high-resistance single-crystal silicon substrate, a superlattice structure buffer layer (SLs), being the buffer layer, is laminated thereon, and a HEMT structure is epitaxially grown on top of that.

Incidentally, it has been known that if the AlN buffer layer is laminated directly on the high-resistance single-crystal silicon substrate, and the buffer layer and the HEMT structure are laminated thereon, the growth rate of AlN is slow, the total epitaxial growth time is extended, Al in the AlN buffer layer is diffused to the high-resistance single-crystal silicon substrate, a low-resistance layer is generated, thereby forming a channel. As a method to reduce the diffusion of Al, most recently, a 3C-SiC on Si epitaxial growth technique is known. This means an intermediate layer 3C-SiC layer is inserted as AlN/3C-SiC/Si. By the 3C-SiC layer, an Al diffusion suppression layer is introduced more easily and efficiently.

In addition, Patent Document 1 discloses a semiconductor structure having SiN between a silicon substrate and a nitride aluminum layer. SiN can be formed before a reaction. SiN includes an amorphous, a single-layer crystal structure, and a polycrystal. In the case of amorphous, what grows thereon is poly-crystallized and does not grow epitaxially. In spite of the reference to CVD process formation, the laminated CVD thin film (2 nm) is poly-crystalized. In addition, even for forming the single-crystal structure SiN, the use of ammonia gas as a nitrogen source gas is described, but the use of ammonia generates cloudiness on the epitaxial wafer.

### CITATION LIST

### PATENT LITERATURE

Patent Document 1: JP 2008-522447 A

### SUMMARY OF INVENTION

### TECHNICAL PROBLEM

The present invention has been made in view of the above-described problem. An object of the present invention is to provide a method for manufacturing a nitride semiconductor substrate that can prevent diffusion of Al to a single-crystal silicon substrate when an AlN layer is epitaxially grown on the single-crystal silicon substrate, and a GaN layer or an AlGaN layer is epitaxially grown on top of that.

### SOLUTION TO PROBLEM

To achieve the object, the present invention provides a method for manufacturing a nitride semiconductor substrate in which a nitride semiconductor is formed on a substrate for film formation, the method comprising the steps of:
(1) subjecting a substrate for film formation made of single-crystal silicon to heat treatment under a nitrogen atmosphere to form a silicon nitride film on the substrate for film formation;
(2) growing an AlN film on the silicon nitride film; and
(3) growing a GaN film, an AlGaN film, or both on the AlN film.

With such a manufacturing method, diffusion of Al from the AlN layer to the single-crystal silicon substrate can be prevented, and a nitride semiconductor substrate can be manufactured without the occurrence of cloudiness.

In addition, in the step (1), the heat treatment is preferably performed in an RTA furnace at 1100 to 1300°C for 1 to 120 seconds.

Such heat treatment can form the silicon nitride film relatively easily.

Moreover, the silicon nitride film is preferably single crystal.

In the present invention, such a silicon nitride film can be formed.

Furthermore, in the present invention, it is preferable to manufacture a nitride semiconductor substrate with an Al diffusion concentration of 4e15 atoms/cm³ or less on the growth substrate surface.

Thus, such a nitride semiconductor substrate with suppressed Al diffusion to the growth substrate surface is particularly useful for manufacturing a high-frequency device.

### ADVANTAGEOUS EFFECTS OF INVENTION

As described above, the present invention can provide a method for manufacturing a nitride semiconductor substrate that can prevent diffusion of Al to the single-crystal silicon substrate without occurring cloudiness when the AlN layer is epitaxially grown on the single-crystal silicon substrate, in particular, on a high-resistance single-crystal silicon substrate and the GaN or the AlGaN layer is epitaxially grown on top of that.

### BRIEF DESCRIPTION OF DRAWINGS

FIG. 1 is a schematic view illustrating an example of a flow diagram of a method for manufacturing a nitride semiconductor substrate according to the present invention.
FIG. 2 is photographs of nitride semiconductor substrates manufactured in Example and Comparative Examples 1 and 2.
FIG. 3 is the measured results of nitride semiconductor substrates manufactured in Example and Comparative Example 3 according to Back Side SIMS.
FIG. 4 is a cross-sectional photograph of a nitride semiconductor substrate manufactured in Example 1.

### DESCRIPTION OF EMBODIMENTS

As described above, the development of a method for manufacturing a nitride semiconductor substrate has been desired in which diffusion of Al to a high-resistance single-crystal silicon substrate is prevented when a nitride semiconductor composed of an AlN buffer layer, a buffer layer, and a GaN-HEMT structure is epitaxially grown on a high-resistance single-crystal silicon substrate.

The present inventors have earnestly studied and found out that a method for manufacturing a nitride semiconductor substrate including: subjecting a substrate for film formation made of single-crystal silicon to heat treatment under a nitrogen atmosphere to form a silicon nitride film; growing an AlN film on the silicon nitride film; and growing a GaN film, an AlGaN film, or both on the AlN film enables to manufacture a nitride semiconductor substrate in which diffusion of Al to a high-resistance single-crystal silicon substrate can be prevented without the occurrence of cloudiness. Based on this finding, the present invention has been completed.

That is, the present invention is a method for manufacturing a nitride semiconductor substrate in which a nitride semiconductor is formed on a substrate for film formation, the method including (1) subjecting a substrate for film formation made of single-crystal silicon to heat treatment under a nitrogen atmosphere to form a silicon nitride film on the substrate for film formation, (2) growing an AlN film on the silicon nitride film, and (3) growing a GaN film, an AlGaN film, or both on the AlN film.

Hereinafter, the present invention will be described in detail. However, the present invention is not limited thereto.

### [Method for Manufacturing Nitride Semiconductor Substrate]

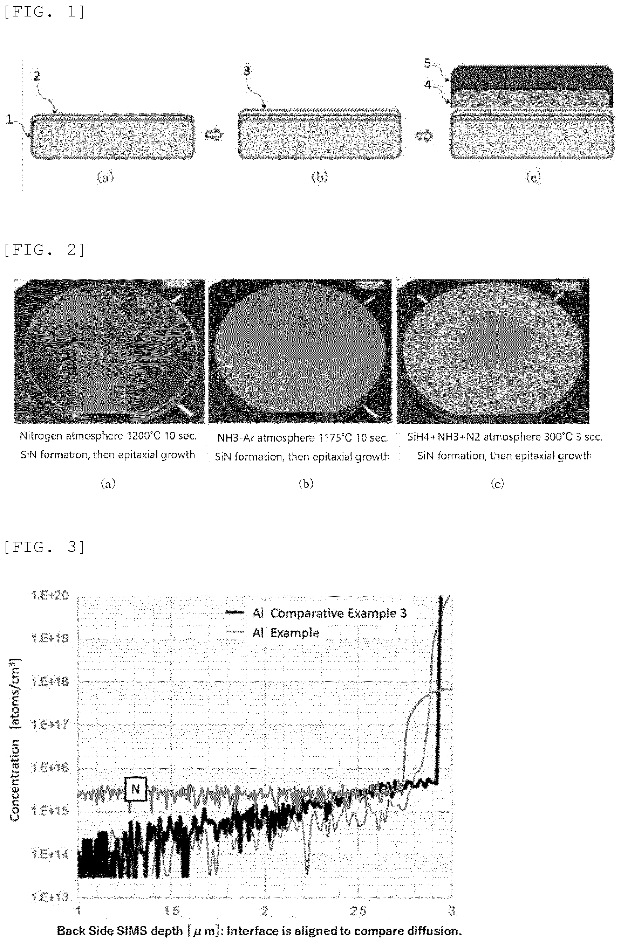

The inventive method for manufacturing the nitride semiconductor substrate includes steps (1) to (3) described below. Hereinafter, referring to the flow diagram of the inventive method for manufacturing the nitride semiconductor in FIG. 1, each step is described in detail.

### <Step (1)>

The step (1) is a step of subjecting a substrate for film formation made of single-crystal silicon to heat treatment under a nitrogen atmosphere to form a silicon nitride film on the substrate for film formation.

To begin with, as shown in FIG. 1(a), a substrate 1 for film formation (silicon substrate) made of single-crystal silicon is put into an RTA (Rapid Thermal Annealing) furnace, and heat treatment is performed under a nitrogen atmosphere, for example, at 1100 to 1300°C for 1 to 120 seconds, preferably at 1150 to 1250°C for 2 to 20 seconds, particularly, at 1200°C for 10 seconds. Thus, the silicon nitride film 2 (SiN film) is formed on the surface, for example, with a thickness of 0.2 to 20 nm, preferably 1 to 4 nm, particularly about 2 nm. The silicon nitride film 2 may be formed only on the front surface of the substrate for film formation but can be formed on the entire surface of the substrate for film formation 1, having a front surface and a back surface.

In particular, the present invention is characterized by forming the silicon nitride film under a nitrogen atmosphere. In this context, the nitrogen atmosphere refers to a 100% nitrogen gas atmosphere or a mixed atmosphere of nitrogen gas and an inert gas. When the silicon nitride film is formed, as described later, the diffusion of Al to the surface of a high resistance single-crystal silicon growth substrate from the AlN buffer layer and generation of a low resistance layer can be prevented. Moreover, when the silicon nitride film is formed by heat treatment under the nitrogen atmosphere, in the following steps, an epitaxial layer of the nitride semiconductor without cloudiness can be grown on the silicon nitride film. When the silicon nitride film is formed by heat treatment under a CVD process or an ammonia gas atmosphere instead of the nitrogen atmosphere, a polycrystal layer may be formed on the silicon nitride film, or cloudiness may occur on the grown epitaxial layer when the nitride semiconductor is grown in the following steps.

The substrate for film formation made of single-crystal silicon is not particularly limited, but may be made of CZ single-crystal silicon or FZ single-crystal silicon, and the presence or absence, type, or concentration of dopant has no particular restriction. Moreover, the substrate for film formation is preferably a high-resistance single-crystal silicon substrate. The resistivity is not particularly limited, but the lower limit is, e.g., 1 Qcm or more, preferably 10 Qcm or more, more preferably 100 Qcm or more, and the upper limit is, e.g., 3000 Qcm or less, preferably 1000 Qcm or less, more preferably 500 Qcm or less.

### <Step (2)>

The step (2) is a step of growing an AlN film on the silicon nitride film.

As shown in FIG. 1(b), an AlN film 3 (AlN buffer layer) is grown on the silicon nitride film 2 by an MOVPE method, e.g., with a thickness of 20 to 500 nm, preferably 50 to 300 nm, more preferably 100 to 200 nm, particularly 160 nm.

### <Step (3)>

The step (3) is a step of growing a GaN film, an AlGaN film, or both on the AlN film.

As shown in FIG. 1(c), for example, a buffer layer 4 composed of a multilayer film including the AlN layer or the GaN layer and the nitride semiconductor composed of a GaN-HEMT layer 5 are epitaxially grown in the total of 0.1 to 20 um, preferably 0.5 to 10 µm, more preferably 1 to 5 µm, particularly about 2.7 µm.

As described above, owing to the silicon nitride film, it is possible to prevent diffusion of Al from the AlN buffer layer to the surface of the high resistance single-crystal silicon growth substrate and the formation of a low resistance layer, and the nitride semiconductor substrate, which has an epitaxial layer without cloudiness grown on the AlN buffer layer, can be manufactured.

Moreover, in the present invention, it is possible to manufacture a nitride semiconductor substrate with an Al diffusion concentration of 4e15 atoms/cm³ or less, preferably 3e15 atoms/cm³ or less, more preferably 2e15 atoms/cm³ or less on the growth substrate surface. The lower limit of the Al diffusion concentration is not particularly limited, but can be, e.g., 0 atoms/cm³ or more, or 1e13 atoms/cm³ or more.

As for the measurement method of the Al diffusion concentration on the growth substrate surface, a secondary ion mass spectroscopy (SIMS) can be used.

### EXAMPLE

Hereinafter, the present invention will be specifically described with reference to Example and Comparative Examples. However, the present invention is not limited thereto.

### (Example)

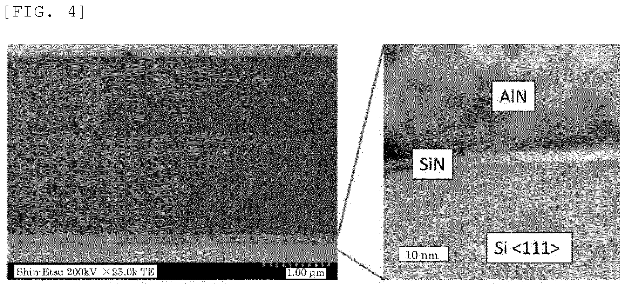

The surface of a single-crystal silicon substrate having 150 mm in diameter, plane orientation (111), and a resistivity of 100 Qcm was coated with a SiN film having a thickness of 2 nm (the surface thereof is converted to SiN by being put into an RTA furnace under N₂ atmosphere at 1200°C for 10 seconds), on which an AlN buffer layer, a buffer layer, and a GaN-HEMT structure were epitaxially grown. After the epitaxial growth, the cross-section of the wafer was observed, and the result is shown in FIG. 4. As shown in FIG. 4, it is confirmed that a flat single-crystal SiN layer has been formed between the silicon substrate and the AlN film. The result of electron beam diffraction proved that the AlN layer was single crystal.

In addition, as shown in FIG. 2(a), the epitaxial layer was found to be grown in a mirror-finished state. Moreover, FIG. 3 shows the results of a Back Side SIMS examination of the Al concentration from the back surface of the single-crystal silicon substrate to the SiN film. In FIG. 3, the sharp increase in the nitrogen (N) concentration indicates the interface between the single-crystal silicon substrate and the AlN film thereon (the silicon nitride film had a thickness of only 2 nm), and it was shown that the Al concentration just below the interface (at a SIMS depth of nearly 2.3 to 2.7 um on the horizontal axis of the graph) was lower than that of Comparative Example 3, which had no SiN film, as described later.

### (Comparative Example 1)

The surface of a single-crystal silicon substrate having 150 mm in diameter, plane orientation (111), and a resistivity of 100 Qcm was coated with a SiN film having a thickness of 2 nm (the surface thereof is converted to SiN by being put into an RTA furnace under NH₃+Ar atmosphere at 1175°C for 10 seconds), and on the Si substrate, an AlN buffer layer, a buffer layer, and a GaN-HEMT structure were epitaxially grown. As shown in 2(b), the epitaxial layer was found to grow with cloudiness.

### (Comparative Example 2)

The surface of a single-crystal silicon substrate having 150 mm in diameter, plane orientation (111), and a resistivity of 100 Qcm was coated with a SiN film having a thickness of 2 nm (the surface thereof is converted to SiN by being put into a PE-CVD furnace under SiH₄+NH₃+N₂ atmosphere at 300°C for 3 seconds), and on the Si substrate, an AlN buffer layer, a buffer layer, and a GaN-HEMT structure were epitaxially grown. As shown in FIG. 2(c), the epitaxial layer was found to grow with cloudiness.

### (Comparative Example 3)

Without forming a SiN film on a Si substrate surface, an AlN buffer layer, a buffer layer, and a GaN-HEMT structure were epitaxially grown directly on the surface of the Si substrate. As shown in FIG. 3, the nitride semiconductor substrate of Comparative Example 3 was found to have a higher Al concentration on the silicon substrate surface, compared with Example.

As described above, according to the inventive method for manufacturing the nitride semiconductor substrate, by forming the nitride silicon film between the single-crystal silicon substrate and the AlN film by heat treatment under the nitrogen atmosphere, the result showed that the nitride semiconductor substrate, which was able to prevent the diffusion of Al to the high-resistance single-crystal silicon substrate without the occurrence of cloudiness, was successfully manufactured. By contrast, in Comparative Example 1 and Comparative Example 2, where the nitride silicon films were formed using conditions other than the nitrogen atmosphere, cloudiness occurred on the epitaxial layer, and in Comparative Example 3, where no nitride silicon film was formed, diffusion of Al to the high-resistance single-crystal silicon substrate was not prevented.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A method for manufacturing a nitride semiconductor substrate in which a nitride semiconductor is formed on a substrate for film formation, the method comprising the steps of:
(1) subjecting a substrate for film formation made of single-crystal silicon to heat treatment under a nitrogen atmosphere to form a silicon nitride film on the substrate for film formation;
(2) growing an AlN film on the silicon nitride film; and
(3) growing a GaN film, an AlGaN film, or both on the AlN film.

2. The method for manufacturing a nitride semiconductor substrate according to claim 1, wherein
in the step (1), the heat treatment is performed in an RTA furnace at 1100 to 1300°C for 1 to 120 seconds.

3. The method for manufacturing a nitride semiconductor substrate according to claim 1 or 2, wherein
the silicon nitride film is single-crystal.

4. The method for manufacturing a nitride semiconductor substrate according to any one of claims 1 to 3, manufacturing
a nitride semiconductor substrate with an Al diffusion concentration of 4e15 atoms/cm³ or less on a growth substrate surface.
